# EUROPEAN PATENT APPLICATION

(11) **EP 3 495 439 A1**
(43) Date of publication of application: **12.06.2019**
(21) Application number: 17837151.4
(22) Date of filing: 16.06.2017
(51) Int. Cl.: C09G 1/02, C09K 3/14, C23F 3/04

(54) **SLURRY COMPOSITION FOR POLISHING TUNGSTEN BARRIER LAYER**

(30) Priority: 05.08.2016 KR 20160099872
(71) Applicant: KCTECH CO., LTD., Anseong-si Gyeonggi-do 17599 (KR)
(72) Inventor: PARK, Han Teo, Anseong-si Gyeonggi-do 17599 (KR); KONG, Hyun Goo, Anseong-si Gyeonggi-do 17599 (KR); LEE, Sang Mi, Anseong-si Gyeonggi-do 17599 (KR)
(74) Representative: Modiano, Micaela Nadia
(86) International application number: PCT/KR2017/006314
(87) International publication number: WO 2018/026099

(57) **Abstract**

The present invention relates to a slurry composition for polishing a tungsten barrier layer. A slurry composition for polishing a tungsten barrier layer according to an embodiment of the present invention comprises abrasive grains and a sulfur-containing amino acid, and can improve edge over erosion (EOE).

## Description

### TECHNICAL FIELD

Example embodiments relate to a slurry composition for polishing a tungsten barrier layer.

### BACKGROUND ART

A chemical mechanical polishing (CMP) process refers to a process of contacting a semiconductor wafer surface with a polishing pad and smoothly performing polishing using a slurry containing an abrasive and various compounds during a rotation movement. CMP slurries may be classified based on a target to be polished. CMP slurries may be broadly classified into an oxide layer polishing slurry for polishing, for example, silicon oxide (SiO₂) that is an insulating layer, and a metal polishing slurry for polishing a metal layer, for example, a copper layer, a tungsten layer, an aluminum layer, and the like. In a process of polishing a metal layer using a metal polishing slurry, a CMP process is performed by a step of polishing an initial metal layer only, a step of polishing a metal layer and a barrier layer, and a step of polishing a metal layer, a barrier layer and an oxide layer. In the last step, that is, the step of polishing the metal layer, the barrier layer and the oxide layer, the metal layer and the oxide layer need to be polished together at an appropriate polishing speed, to achieve excellent polishing planarization. Erosion may occur due to partial overpolishing caused by a distribution pattern of the metal layer, a pattern density, and the like. Also, an edge over erosion (EOE) may be further eroded in a portion in which a pattern density changes. Since a polishing state of a target material to be polished has an influence on a formation of a pattern in a subsequent photolithography, a margin of a depth of focus (DOF) in the subsequent photolithography may decrease when an EOE occurs due to a poor polishing state of the target material. Thus, a shape of a pattern formed in a subsequent process may be defective, or a wiring pattern may be broken, which may have a very serious influence on the semiconductor device.

### DISCLOSURE OF INVENTION

### TECHNICAL SUBJECT

The present disclosure is to solve the foregoing problems, and an aspect of the present disclosure is to provide a slurry composition for polishing a tungsten barrier layer which may increase a degree of planarization by eliminating defects, such as a desired edge over erosion (EOE) or erosion, and which may be used to uniformly polish the tungsten barrier layer after a chemical mechanical polishing (CMP) process is performed.

However, the problems to be solved in the present disclosure are not limited to the foregoing problems, and other problems not mentioned herein would be clearly understood by one of ordinary skill in the art from the following description.

### TECHNICAL SOLUTION

According to an aspect, there is provided a slurry composition for polishing a tungsten barrier layer including: abrasive particles; and a sulfur-containing amino acid.

The abrasive particles may include at least one selected from the group consisting of a metal oxide, a metal oxide coated with an organic material or inorganic material, and the metal oxide in a colloidal phase. The metal oxide may include at least one selected from the group consisting of silica, ceria, zirconia, alumina, titania, barium titania, germania, mangania and magnesia.

The abrasive particles may have a particle size of 40 nm to 100 nm, or at least two different particle sizes.

The abrasive particles may be present in an amount of 1 wt % to 10 wt % in the slurry composition.

The sulfur-containing amino acid may include at least one selected from the group consisting of cysteine, methionine, cystine, thiocysteine, taurine, taurocholic acid, N-acyl methyl taurates, djenkolic acid, cystathionine, S-allyl cysteine, lanthionine, ethionine, S-adenosylmethionine, glutathione and N-acetylcysteine.

The sulfur-containing amino acid may be present in an amount of 0.001 wt % to 1 wt % in the slurry composition.

When a tungsten barrier layer is polished using the slurry composition, an edge of erosion (EOE) may be measured under conditions of a speed of 10 µm/s to 30 µm/s, a rate of 10 Hz to 30 Hz and a force of 1 mg to 5 mg. A line width of each of a tungsten metal film and an insulating film may be 10 µm, and an EOE value of a tungsten barrier layer with a pattern density of 30% may be less than 200 Å.

The slurry composition may further include at least one selected from the group consisting of a corrosion inhibitor, a pH buffering agent and an oxidizer.

The corrosion inhibitor may include at least one selected from the group consisting of glycine, arginine, cysteine, glutamine, ethylenediamine tetra acetic acid, diethylamine, triethylamine, pyrrolidine, trimethylamine, cyclopropylethylmethylamine, ethylene diamine, iminodiacetic acid, alanine, valine, glutamic acid, aspartic acid, asparagine, serine, threonine, methionine, histidine, phenylalanine, lysine, hydroxyethyl iminodiacetic acid, diethylenetriamine pentaacetic acid, N-[2-acetamido]-2-iminodiacetic acid, dimethylamine, diethylamine, and taurine.

The corrosion inhibitor may be present in an amount of 0.001 wt % to 1 wt % in the slurry composition.

The pH buffering agent may include at least one selected from the group consisting of ammonium phosphate, ammonium hydrogen phosphate, ammonium dihydrogen phosphate, ammonium hydroxide, ammonium acetate, ammonium borate, ammonium oxalate, dibasic ammonium citrate, tribasic ammonium citrate, ammonium carbamate, dibasic ammonium citrate and tribasic ammonium citrate.

The pH buffering agent may be present in an amount of 0.005 wt % to 0.2 wt % in the slurry composition.

The oxidizer may include at least one selected from the group consisting of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide and urea peroxide.

The oxidizer may be present in an amount of 0.01 wt % to 5 wt % in the slurry composition.

The slurry composition may have a pH ranging from 1 to 5.

### EFFECT

According to example embodiments, a slurry composition for polishing a tungsten barrier layer may be used to minimize a step height between a portion in which a pattern is formed and a portion in which a pattern is not formed, by adding a sulfur-containing amino acid and abrasive particles with a size smaller than that of abrasive particles used according to a related art, thereby reducing an edge over erosion (EOE) and erosion.

### BRIEF DESCRIPTION OF DRAWINGS

FIG. 1 is a graph illustrating a polishing state based on a pattern density after a tungsten barrier layer is polished; and
FIG. 2 is a graph illustrating results obtained by measuring an edge over erosion (EOE) based on a pattern density after polishing is performed using a slurry composition for polishing a tungsten barrier layer prepared according to an example and polishing slurry compositions prepared according to Comparative Examples 1 and 2 according to an example embodiment.

### BEST MODE FOR CARRYING OUT THE INVENTION

Hereinafter, example embodiments of the present disclosure will be described in detail with reference to the accompanying drawings. When it is determined detailed description related to a related known function or configuration they may make the purpose of the present disclosure unnecessarily ambiguous in describing the present disclosure, the detailed description will be omitted here. Also, terminologies used herein are defined to appropriately describe the example embodiments and thus may be changed depending on a user, the intent of an operator, or a custom of a field to which the present disclosure pertains. Accordingly, the terminologies must be defined based on the following overall description of this specification. Like reference numerals illustrated in the drawings refer to like constituent elements throughout the specification.

Throughout the whole document, the term "comprises or includes" and/or "comprising or including" specify the presence of stated elements or components, but do not preclude the presence or addition of one or more other elements or components, unless mentioned otherwise.

Hereinafter, a slurry composition for polishing a tungsten barrier layer according to example embodiments of the present disclosure will be described in detail with reference to examples and drawings. However, the present disclosure is not limited to the examples and drawings.

According to an example embodiment, a slurry composition for polishing a tungsten barrier layer (hereinafter, referred to as a "slurry composition") may include abrasive particles, and a sulfur-containing amino acid.

Due to an edge over erosion (EOE) and erosion, wiring layers may have different thicknesses, which may lead to a reduction in a uniformity of an operation of a device and a difficulty to strictly control a margin of a depth of focus (DOF). To eliminate a difference in a degree of planarization based on a pattern density for each region on a wafer or a chip, a method of forming an additional insulating layer and planarizing the additional insulating layer may be used. However, in the present disclosure, a slurry composition for polishing a tungsten barrier layer may be enhanced, thereby solving problems of an EOE and erosion.

The slurry composition may be used minimize a step height between a portion in which a pattern is formed and a portion in which a pattern is not formed, by adding a sulfur-containing amino acid and abrasive particles with a size smaller than that of abrasive particles used according to a related art, thereby reducing an edge over erosion (EOE) and erosion.

The abrasive particles may include at least one selected from the group consisting of a metal oxide, a metal oxide coated with an organic material or inorganic material, and the metal oxide in a colloidal phase. The metal oxide may include at least one selected from the group consisting of silica, ceria, zirconia, alumina, titania, barium titania, germania, mangania and magnesia.

The abrasive particles may have a particle size of 40 nm to 100 nm, or at least two different particle sizes, to reduce an EOE phenomenon. When the particle size of the abrasive particles is less than 40 nm, a tungsten film may be overpolished. When the particle size of the abrasive particles exceeds 100 nm, an insulating film may be overpolished, and it may be difficult to control dishing, a surface defect and a polishing rate. Thus, it is possible to reduce the EOE phenomenon using abrasive particles with a smaller particle size than that of abrasive particles included in an existing polishing slurry.

The abrasive particles may be present in an amount of 1 wt % to 10 wt % in the slurry composition. When the amount of the abrasive particles is less than 1 wt %, the polishing speed may decrease. When the amount of the abrasive particles exceeds 10 wt %, the polishing speed may excessively increase, and surface defects may occur due to adsorbability of particles remaining on a surface caused by an increase in a number of abrasive particles.

The sulfur-containing amino acid may have an effect of a protective film for a tungsten film, thereby reducing an EOE phenomenon occurring in a boundary between a region with a high tungsten pattern density and a region with a low tungsten pattern density.

The sulfur-containing amino acid may include at least one selected from the group consisting of cysteine, methionine, cystine, thiocysteine, taurine, taurocholic acid, N-acyl methyl taurates, djenkolic acid, cystathionine, S-allyl cysteine, lanthionine, ethionine, S-adenosylmethionine, glutathione and N-acetylcysteine. The cysteine, the methionine and the cystine may include, but are not particularly limited to, at least one selected from the group consisting of L-cysteine, DL-cysteine, D-cysteine, L-methionine, DL-methionine, D-methionine, L-cystine, DL-cystine and D-cystine.

The sulfur-containing amino acid may be present in an amount of 0.001 wt % to 1 wt % in the slurry composition. When the amount of the sulfur-containing amino acid is less than 0.001 wt %, it may be difficult to expect a function to reduce the EOE phenomenon. When the amount of the sulfur-containing amino acid exceeds 1 wt %, a polishing rate of a tungsten barrier layer may decrease.

The slurry composition may be used to reduce an EOE of the tungsten barrier layer.

For example, when a tungsten barrier layer is polished using the slurry composition, an EOE may be measured under conditions of a speed of 10 µm/s to 30 µm/s, a rate of 10 Hz to 30 Hz and a force of 1 mg to 5 mg, a line width of each of a tungsten film and an insulating film may be 10 µm, and an EOE value of a tungsten barrier layer with a pattern density of 30% may be less than 200 Å. Generally, in a photolithography, an allowable DOF may be set to 200 Å. The slurry composition according to an example embodiment may control a step height due to an EOE to be 200 Å or less while maintaining a polishing speed of the tungsten barrier layer.

The slurry composition may further include at least one selected from the group consisting of a corrosion inhibitor, a pH buffering agent and an oxidizer.

The corrosion inhibitor may include at least one selected from the group consisting of glycine, arginine, cysteine, glutamine, ethylenediamine tetra acetic acid, diethylamine, triethylamine, pyrrolidine, trimethylamine, cyclopropylethylmethylamine, ethylene diamine, iminodiacetic acid, alanine, valine, glutamic acid, aspartic acid, asparagine, serine, threonine, methionine, histidine, phenylalanine, lysine, hydroxyethyl iminodiacetic acid, diethylenetriamine pentaacetic acid, N-[2-acetamido]-2-iminodiacetic acid, dimethylamine, diethylamine, and taurine.

The corrosion inhibitor may be present in an amount of 0.001 wt % to 1 wt % in the slurry composition in terms of a corrosion inhibition effect, a polishing speed and a storage stability of the slurry composition. When the amount of the corrosion inhibitor is less than 0.001 wt %, a surface problem, for example, dishing or erosion, may occur due to impossibility to control polishing of a tungsten film. When the amount of the corrosion inhibitor exceeds 1 wt %, a removal rate of a metal film may decrease and organic residues may remain.

The pH buffering agent may be used to prevent a pH from suddenly changing when an additive and a solution in which abrasive particles are dispersed are mixed, thereby increasing a long-term storage stability by stably maintaining the pH of the slurry composition. The pH buffering agent may indirectly function to maintain a polishing speed by maintaining a variation in the pH of the slurry composition to 0.05 or less for 30 days, and may provide convenience of supply, maintenance and storage.

The pH buffering agent may include at least one selected from the group consisting of ammonium phosphate, ammonium hydrogen phosphate, ammonium dihydrogen phosphate, ammonium hydroxide, ammonium acetate, ammonium borate, ammonium oxalate, dibasic ammonium citrate, tribasic ammonium citrate, ammonium carbamate, dibasic ammonium citrate and tribasic ammonium citrate.

The pH buffering agent may be present in an amount of 0.005 wt % to 0.2 wt % in the slurry composition. When the amount of the pH buffering agent is less than 0.005 wt %, the pH buffering agent may not function as a pH buffering agent. When the amount of the pH buffering agent exceeds 0.2 wt %, a polishing rate may increase and dispersibility of abrasive particles may decrease, which may lead to defects, for example, scratches on a surface of a tungsten barrier layer.

The oxidizer may include a material that removes metal electrons and increases a valence, and may be used to easily remove an oxide film formed on a surface of a tungsten barrier layer during polishing, to achieve a relatively high polishing speed.

The oxidizer may include at least one selected from the group consisting of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide and urea peroxide.

The oxidizer may be present in an amount of 0.01 wt % to 5 wt % in the slurry composition. When the amount of the oxidizer is less than 0.01 wt %, a polishing speed and an etching speed of the tungsten barrier layer may decrease due to excessively weak oxidizing power. When the amount of the oxidizer exceeds 5 wt %, an oxide film on a surface of the tungsten barrier layer may become hard so that polishing may not be smoothly performed and the oxide film may grow to cause corrosion and erosion of tungsten, thus resulting in inferior topography.

The slurry composition may further include at least one pH adjuster to prevent corrosion of a metal or abrader and to realize a pH range in which metal is easily oxidized. The pH adjuster may include at least one selected from the group consisting of an acidic material including at least one selected from the group consisting of hydrochloric acid, phosphoric acid, sulfuric acid, hydrofluoric acid, bromic acid, iodic acid, formic acid, malonic acid, maleic acid, oxalic acid, acetic acid, adipic acid, citric acid, adipic acid, acetic acid, propionic acid, fumaric acid, lactic acid, salicylic acid, pimelic acid, benzoic acid, succinic acid, phthalic acid, butyric acid, glutaric acid, glutamic acid, glycolic acid, lactic acid, asparaginic acid, tartaric acid and salts thereof; and a basic material including at least one selected from the group consisting of ammonia, ammonium methyl propanol (AMP), tetramethylammonium hydroxide (TMAH), potassium hydroxide, sodium hydroxide, magnesium hydroxide, rubidium hydroxide, cesium hydroxide, sodium hydrogen carbonate, sodium carbonate and imidazole.

The slurry composition may have a pH ranging from 1 to 5, based on a polishing speed, dispersion stability, and the like. When the pH of the slurry composition is out of the above range, a polishing speed of a tungsten barrier layer may decrease, defects, for example, erosion, etching, dishing or surface unevenness, may occur, and a surface roughness may be variable. The pH may be adjusted by adding the pH adjuster.

Hereinafter, the present disclosure will be described in detail with reference to an example and comparative examples. However, the technical idea of the present disclosure is not limited or restricted to the examples.

### [Examples]

### <Example>

1.5 wt % of colloidal silica abrasive particles with a particle size of 65 nm, 0.02 wt % of cysteine as a sulfur-containing amino acid, 0.016 wt % of glycine as a corrosion inhibitor, 0.03 wt % of ammonium phosphate as a pH buffering agent, and 0.3 wt % of hydrogen peroxide as an oxidizer were mixed, and a pH was adjusted to 2.5 using nitric acid, to prepare a slurry composition for polishing a tungsten barrier layer.

### <Comparative Example 1>

A slurry composition was prepared in the same manner as in the example except that cysteine as a sulfur-containing amino acid was not added.

### <Comparative Example 2>

A slurry composition was prepared in the same manner as in the example except that colloidal silica abrasive particles with a particle size of 150 nm were added and cysteine as a sulfur-containing amino acid was not added.

Tungsten wafers with pattern densities of 10%, 30%, 50%, 70% and 90% were polished using the polishing slurry compositions prepared according to the example and Comparative Examples 1 and 2 under the following polishing conditions.

### <Polishing Conditions>

1. Polishing equipment: 300 mm ST-01
2. Platen speed: 100 rpm
3. Carrier speed: 103 rpm
4. Wafer pressure: 3 psi
6. Flow rate: 200 ml/min

An EOE of each of the tungsten wafers with pattern densities of 10%, 30%, 50%, 70% and 90% after the tungsten wafers were polished using the slurry composition prepared according to the example and the polishing slurry compositions prepared according to Comparative Examples 1 and 2 was measured under the following measuring conditions.

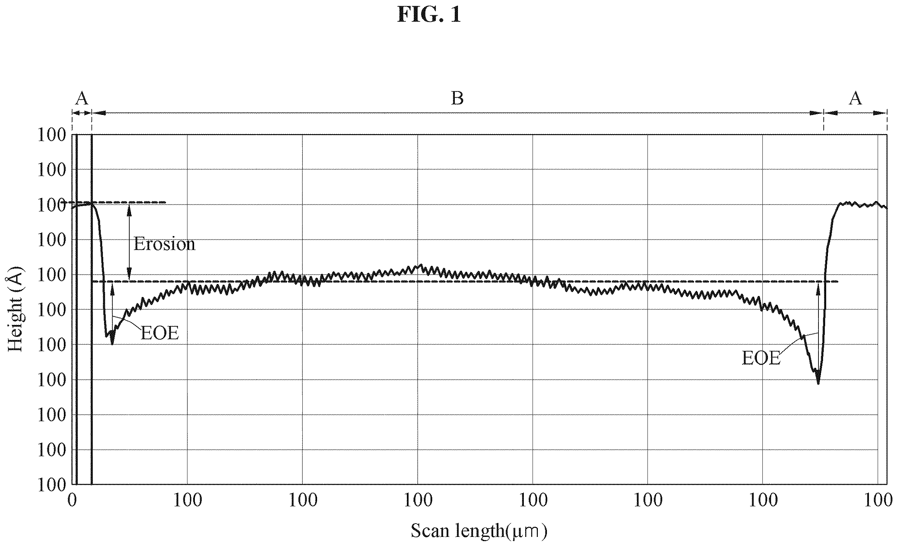

FIG. 1 is a graph illustrating a polishing state based on a pattern density after a tungsten barrier layer is polished. FIG. 1 illustrates an erosion in which a portion B in which a pattern is formed becomes lower than a neighboring portion A in which a pattern is not formed, due to a difference in a polishing speed, when a tungsten barrier layer is polished. A boundary between the portions A and B is eroded further than a level of the erosion, that is, an EOE occurs.

### <EOE Measurement Conditions>

1. Measuring equipment: KLA-Tencor P-170F
2. Speed: 20 µm/s
3. Rate: 20 Hz
4. Force: 2 mg

Table 1 shows results obtained by measuring an EOE based on a pattern density after polishing is performed using the slurry composition prepared according to the example and the polishing slurry compositions prepared according to Comparative Examples 1 and 2. A pattern density of 10% refers to a pattern in which a line pattern and a space pattern are alternately arranged at a width ratio of 10 : 90, and a pattern density of 50% refers to a pattern in which a line pattern and a space pattern are alternately arranged at a width ratio of 50 : 50.

**[Table 1]**

| Pattern density | Example EOE | Comparative Example 1 EOE | Comparative Example 2 EOE |
|---|---|---|---|
| | (Å) | (Å) | (Å) |
| 10% | 57 | 88 | 232 |
| 30% | 174 | 214 | 293 |
| 50% | 59 | 126 | 134 |
| 70% | 24 | 82 | 132 |
| 90% | 89 | 52 | 108 |

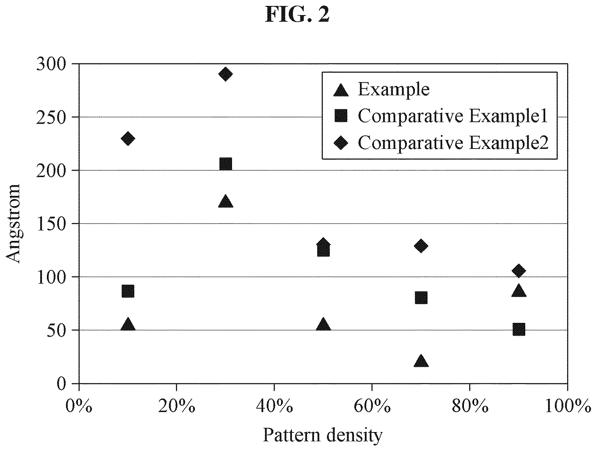

FIG. 2 is a graph illustrating results obtained by measuring an EOE based on a pattern density after polishing is performed using the slurry composition prepared according to the example and the polishing slurry compositions prepared according to Comparative Examples 1 and 2 according to an example embodiment. Referring to FIG. 2, it is confirmed that in Comparative Examples 1 and 2, EOE values remarkably increase in comparison to the example. Based on the above results, it is confirmed that the slurry composition prepared according to the example may be used to control a step height due to erosion to be 200 Å or less while maintaining a polishing speed of the tungsten barrier layer.

Although a few embodiments of the present disclosure have been shown and described, the present disclosure is not limited to the described embodiments. Instead, it would be appreciated by those skilled in the art that changes may be made to these embodiments without departing from the principles and spirit of the present disclosure, the scope of which is defined by the claims and their equivalents.

## Claims

1. A slurry composition for polishing a tungsten barrier layer, the slurry composition comprising:
abrasive particles; and
a sulfur-containing amino acid.

2. The slurry composition of claim 1, wherein
the abrasive particles comprise at least one selected from the group consisting of a metal oxide, a metal oxide coated with an organic material or inorganic material, and the metal oxide in a colloidal phase, and
the metal oxide comprises at least one selected from the group consisting of silica, ceria, zirconia, alumina, titania, barium titania, germania, mangania and magnesia.

3. The slurry composition of claim 1, wherein the abrasive particles have a particle size of 40 nm to 100 nm, or at least two different particle sizes.

4. The slurry composition of claim 1, wherein the abrasive particles are present in an amount of 1 wt % to 10 wt % in the slurry composition.

5. The slurry composition of claim 1, wherein the sulfur-containing amino acid comprises at least one selected from the group consisting of cysteine, methionine, cystine, thiocysteine, taurine, taurocholic acid, N-acyl methyl taurates, djenkolic acid, cystathionine, S-allyl cysteine, lanthionine, ethionine, S-adenosylmethionine, glutathione and N-acetylcysteine.

6. The slurry composition of claim 1, wherein the sulfur-containing amino acid are present in an amount of 0.001 wt % to 1 wt % in the slurry composition.

7. The slurry composition of claim 1, wherein
when a tungsten barrier layer is polished using the slurry composition, an edge of erosion (EOE) is measured under conditions of a speed of 10 µm/s to 30 µm/s, a rate of 10 Hz to 30 Hz and a force of 1 mg to 5 mg,
a line width of each of a tungsten metal film and an insulating film is 10 µm, and
an EOE value of a tungsten barrier layer with a pattern density of 30% is less than 200 Å.

8. The slurry composition of claim 1, further comprising:
at least one selected from the group consisting of a corrosion inhibitor, a pH buffering agent and an oxidizer.

9. The slurry composition of claim 8, wherein the corrosion inhibitor comprises at least one selected from the group consisting of glycine, arginine, cysteine, glutamine, ethylenediamine tetra acetic acid, diethylamine, triethylamine, pyrrolidine, trimethylamine, cyclopropylethylmethylamine, ethylene diamine, iminodiacetic acid, alanine, valine, glutamic acid, aspartic acid, asparagine, serine, threonine, methionine, histidine, phenylalanine, lysine, hydroxyethyl iminodiacetic acid, diethylenetriamine pentaacetic acid, N-[2-acetamido]-2-iminodiacetic acid, dimethylamine, diethylamine, and taurine.

10. The slurry composition of claim 8, wherein the corrosion inhibitor is present in an amount of 0.001 wt % to 1 wt % in the slurry composition.

11. The slurry composition of claim 8, wherein the pH buffering agent comprises at least one selected from the group consisting of ammonium phosphate, ammonium hydrogen phosphate, ammonium dihydrogen phosphate, ammonium hydroxide, ammonium acetate, ammonium borate, ammonium oxalate, dibasic ammonium citrate, tribasic ammonium citrate, ammonium carbamate, dibasic ammonium citrate and tribasic ammonium citrate.

12. The slurry composition of claim 8, wherein the pH buffering agent is present in an amount of 0.005 wt % to 0.2 wt % in the slurry composition.

13. The slurry composition of claim 8, wherein the oxidizer comprises at least one selected from the group consisting of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide and urea peroxide.

14. The slurry composition of claim 8, wherein the oxidizer is present in an amount of 0.01 wt % to 5 wt % in the slurry composition.

15. The slurry composition of claim 1, wherein the slurry composition has a pH ranging from 1 to 5.
